# EUROPEAN PATENT APPLICATION

(11) **EP 1 274 121 A1**
(43) Date of publication of application: **08.01.2003**
(21) Application number: 01115947.2
(22) Date of filing: 29.06.2001
(51) Int. Cl.: H01L 21/00

(54) **Wafer chuck for supporting a semiconductor wafer**

(71) Applicant: Infineon Technologies SC300 GmbH & Co. KG, 01099 Dresden (DE)
(72) Inventor: Koestler, Wolfram, 01465 Langebrück (DE); Hraschan, Guenther, 01109 Dresden (DE)
(74) Representative: Epping Hermann & Fischer

(57) **Abstract**

The invention relates to a wafer chuck (1) for supporting a semiconductor wafer (10) in a lithography device (9). The chuck comprises a wafer support region (2) constructed for contacting a planar wafer surface (11). According to the invention the wafer support region (2) of the chuck (1) comprises recesses (3) allocated at predefined positions (4) corresponding to support member contacting portions (12) of the lower wafer surface (11). A wafer handling system comprises the wafer chuck (1) according to the invention and a wafer holder having wafer support members predefining the support member contacting portions (12) of the wafer surface (11). Elevations on the lower wafer surface like scratches or deposited material which are produced by the contact of the support members (21) and the wafer (10) are encapsulated by the recesses (3) of the wafer chuck according to the invention. Thereby safe contact of the wafer (10) and the wafer support region (2) of the chuck (3) is achieved during lithographic exposure of the wafer.

## Description

The present invention relates to a wafer chuck for supporting a semiconductor wafer in semiconductor product manufacturing, the wafer chuck having a wafer support region for supporting the wafer, the wafer support region being constructed for contacting a planar wafer surface.

In semiconductor product manufacturing semiconductor wafers are processed in order to form integrated circuits thereon. A single wafer is subjected to about a few hundreds of processing steps performed in several processing tools.

Wafer processing requires very precise positioning of the wafer during some process steps defining an integrated circuit structure. Especially during lithographic exposure a highly precise positioning of the wafer in a lithography tool is very important for sufficient alignment with integrated structures already existing on the wafer.

Wafer positioning includes correct lateral adjustment of the wafer position. Commonly this is accomplished by steppers used for multiple exposure in lithography tools.

Furthermore, precise wafer positioning requires sufficient control of the wafer position in the direction perpendicular to the planar wafer surface. As each wafer is exposed to exposure light from this direction during a lithography step, the distance between the wafer and the exposure beam source or, if the wafer is oriented horizontally during exposure, the vertical position of the wafer has a great influence on focus control. Any deviation of the vertical position of the upper wafer surface to be exposed from the position required leads to defocusing and, as a consequence, to the production of lithographic structures of minor quality. Wafers exposed in such a way often are rejected because of bad critical dimension or misalignment to existing integrated structures.

Due to progressing miniaturization and integration the exposure wavelength and, as a consequence, the depth of focus achievable with the respective wavelength decrease. Current lithography tools generate exposure light of a wavelength of 248 or 193 nm in UV-range. Operating in this sub-µ-range requires highly precise positioning of the wafer in the direction perpendicular to the wafer surface plane.

In a lithography tool a wafer is supported by a wafer chuck supporting the backside of the wafer from below and thereby adjusting the height of the upper wafer surface to be exposed. The wafer chuck has a wafer support region for receiving the wafer and being constructed for contacting the lower planar wafer surface. The cross section of the wafer support region is substantially equal to the circumference of the planar wafer surface of the wafers to be supported.

When a wafer is resting on the wafer chuck, the height of the wafer in general is predefined by the height of the chuck or its wafer support region, respectively. However, often the back surface of the wafer is providing microscopic protrusions or elevations unintentionally produced during preceding processing steps. There may be various processing steps leading to such irregularities. Predominantly hot diffusion and deposition processes performed in high temperature furnaces cause these elevations.

There are at least two effects producing elevations on the contacted lower surface of a wafer in a high temperature furnace.

First, the speed of deposition of substances to be deposited onto a wafer which is accessible from both sides is increased in direct vicinity to support member contacting portions of the wafer backside. Adjacent to these support member contacting portions of the wafer and support members supporting the wafer at these contacting portions, process gas flow is inhibited at least by the presence of the support member like a finger-like quartz member, for instance This may lead to an increased deposition rate near the contact area.

Second, thermal expansion of the silicon wafers themselves relative to the quartz fingers may lead to scratches produced by lateral movement of the quartz finger tips relative to the lower wafer surface. Current hot diffusion processes require temperatures of 1000°C and above, thereby producing a comparatively large movement due to thermal expansion. Furthermore, current 300mm-wafers are rather heavy and produce a high pressure onto the quartz finger tips caused by their weight. When the position of a wafer is displaced relative to a quartz finger due to thermal expansion, the movement of the quartz finger relative to the lower wafer surface produces scratches surrounded by elevating walls on both sides of the scratches. The weight of a 300mm-wafer leads to a relatively high pressure of the quartz finger tip onto the lower wafer surface and, as a consequence, to deeper scratches and higher adjacent elevating walls.

These irregularities deteriorate the planarity of the wafer back surface and lead to misalignments of the wafer position in the direction perpendicular to its wafer surface when the wafer is resting on a wafer chuck. As a consequence, defocusing is caused during lithographic exposure.

Whereas overall deviations from the height of a wafer supported by a wafer chuck may be corrected by appropriate wafer chuck positioning, local misalignments of the wafer position cannot be corrected in this way.

Due to the elasticity of the wafer material (like silicon or another metal) a wafer having microscopic elevations on its lower wafer surface is resting slightly deformed on the wafer chuck. In those surface regions covered with microscopic elevations and in their vicinity, the upper surface of the wafer is slightly elevated compared to surrounding portions of the upper wafer surface.

Hence the elevations on the lower wafer surface are locally lifting the wafer from the wafer chuck whereas remote from these elevations the wafer surface is slightly concavely deformed and resting on the wafer chuck in direct contact to the wafer support region of the chuck.

Thereby local regions of defocussing, so-called focus spots, are caused at the lateral position of the backside elevations when a wafer is exposed to exposure light. In the area of the focus spots the upper wafer surface is located out of the depth of focus. Thereby wafer surface is wasted because some semiconductor products produced will be rejected.

There are various attempts to overcome this problem by cleaning the wafer backside. However, all these cleaning methods do not successfully remove the elevations from the back surface of the wafers.

It has been recognized that sometimes the focus spot vanishes after a rotation of the wafer on the wafer chuck. In the case of a vacuum chuck like a ring chuck or a pin chuck the wafer support region of the chuck is formed of a multitude of pins or concentric rings forming the contact area for contacting the backside of a wafer. If a wafer is resting on such a vacuum chuck and an elevation is located on one of the pins or rings, the focus spot appears. In the case that the elevation is located just between adjacent pins or rings, the focus spot vanishes.

However, according to this method there is only an accidental chance of overcoming the problem of local wafer lifting in this way and additional efforts for surveying the appearance of focus spots are required.

It is the object of the present invention to reliably avoid the appearance of focus spots when a wafer resting on a wafer chuck is exposed to lithographic exposure light.

This object is achieved by a wafer chuck as initially disclosed, the wafer support region of wafer chuck comprising recesses allocated at predefined positions corresponding to support member contacting portions of the wafer surface.

According to the invention recesses are provided in the wafer support region of the chuck. These recesses are located such that their positions correspond to those portions of the wafer backside which might have come into contact with any support members during preceding wafer processing.

The present invention exploits the fact that those portions of the wafer backside where elevations or protrusions might occur often are located at the same lateral positions and at the same distances from each other. This regularity of lateral elevation positions is caused by the manner the wafer is contacted before being transferred to the chuck.

In a high temperature furnace for instance one or more lots of wafers are supported by a quartz boat. Wafers and, predominantly, 300mm wafers are supported in a horizontal position when they are resting on a quartz boat in a furnace.

Typically several dozens of wafers are supported by one single quartz boat, each wafer being supported by a triple of finger-like wafer support members forming part of the quartz boat. These support members are constructed such that they have a minimum dot-like contact area to the wafer when supporting it. The positions of the three fingers to each other are fixed so that the positions of the dot-like contact areas to each other are fixed for all wafers too.

As current wafer handling is very precise the positions of support member contacting portions on the backside of wafers may be identified. Furthermore, as these support member contacting portions are rather small compared to the cross-section of the backside wafer surface, it is possible to adapt the shape of the wafer support region of the wafer chuck to the positions and the dimensions of elevations probably existing on a wafer backside. Accordingly safe protection from focus spots on wafers resting on a wafer chuck during lithographic exposure is achieved.

Preferably the wafer chuck comprises three recesses in the wafer support region, the recesses being allocated symmetrically around the center of the wafer support region. As this is the minimum number of contact points for supporting a wafer during preceding wafer processing, it is advantageous to provide the equal number of recesses on the chuck. The recesses are sufficiently large in lateral dimension to safely surround any elevations in the predefined areas on the wafer backside.

Preferrably the recesses are allocated symmetrically around the center of the wafer support region and, as a consequence, around the center of the wafer backside. This grants for safe focus spot protection even in the case that the wafer is rotated by 120° or 240° around the axis perpendicular to the center of the wafer plane when the wafer is resting on the wafer chuck. In this case the distance of each recess from the center of the wafer support region is equal.

Preferably the recesses have a circular cross-section in the wafer support region. A circular cross-section is easy to produce by merely drilling a hole into the wafer chuck surface.

Preferably the cross-section of the recesses is 5 to 15 mm in diameter. This contour of the recesses is large enough to safely surround any elevations adjacent to the wafer contacting regions and to encapsulate them from below so that according to the invention the wafer backside is completely contacting the wafer support region of the chuck, any elevations on the wafer backside being surrounded by recesses.

In a furnace often a triple of support members are used for supporting wafers during wafer processing. This triple of wafer support members often produces six elevations or protrusions, two elevations or protrusions being adjacent to one respective contact area of the wafer backside and one support member. In a furnace semiconductor wafers are subjected to thermal expansion which may lead to wafer plane deformation bending the wafer plane to some extent, thereby producing pairs of elevations azimuthally adjacent to the actual wafer contacting portions.

Two alternative embodiments are disclosed to safely surround these pairs of elevations.

According to a first embodiment the recesses may have an elliptical cross-section in the wafer support region. Preferra ly the recesses are allocated such that the larger extension of the elliptical cross-section is oriented towards the interconnection between two adjacent elevations whereas the smaller extension of the elliptical cross-section is extending in radial direction.

According to a second embodiment the wafer chuck may comprise three pairs of recesses, both recesses of each respective pair being allocated adjacent to each other and the three pairs of recesses being allocated symmetrically around the center of the wafer support region. According to this embodiment a very high planarity of the wafer supported by the chuck is achieved due to mimimum cross-section of the recesses.

In contrast to the lateral extension of wafer backside elevations like scratches which are rather extended compared to microelectronic structures, the height of such elevations on the wafer backside is rather small. As a consequence the recesses may be rather shallow for sufficient protection-from lifting the wafer from the chuck. Preferably the depth of the recesses is between 10 and 100 µm from the wafer support region. However, any larger depth of the recesses may also be realized. Accordingly the recesses may be either hollow caves or cut-outs extending over the complete depth of the wafer support region of the chuck.

There are wafer chucks provide a wafer support region designed as a planar support surface of essentially circular cross-section. Especially when the wafer chuck is an electrostatic chuck, the full area within the wafer support region is a contact surface contacting the wafer backside when a wafer is resting on the chuck.

However, there are other designs of wafer support regions constructed for contacting a planar wafer surface. If the wafer chuck is a vacuum chuck, the wafer supported by the chuck is exposed to vacuum suction from the wafer backside in order to safely control the wafer position by the position the wafer support region of the wafer chuck. By providing vacuum suction highly precise positioning of the wafer in the direction perpendicular to the wafer plane is achieved.

In order to exert suction onto the wafer backside, the wafer support region of the wafer chuck is designed as a pattern of either pins or concentric rings, the pins or rings forming segments of contact surfaces for contacting the wafer backside resting on the wafer support region. Between these segments ditches or conduits are provided for applying vacuum suction on the wafer backside.

According to the invention the recesses for encapsulating elevations are superimposed to these designs of wafer support regions. According to the preferred embodiments of a vacuum chuck, the chuck is a pin chuck or a ring chuck, the three recesses being cut-outs in the pattern of pins or rings.

The object of the invention is further achieved by a wafer handling system comprising a wafer chuck according to one of the above embodiments, the wafer handling system further comprising a wafer holder having a set of minimum contact wafer support members, the wafer support members predefining support member contacting portions on the planar wafer surface.

When a semiconductor wafer is processed by a processing tool and supported by the wafer holder during wafer processing, the wafer support members of the wafer holder are allocated such that they predefine support member contacting portions on the backside of the wafer. As the distance between these support member contacting portions from each other are fixed due to fixed locations of the wafer support members, the locations of the contact surfaces between the wafer support members of the wafer holder and the wafer backside correspond to the allocation of the recesses of the wafer chuck. The positions of the wafer support members predefine the location of the support member contacting portions of the wafer backside and the support member contacting portions in turn predefine the positions of the recesses in the wafer support region of the wafer chuck. Thereby a 1:1-correspondence between a wafer holder construction and a wafer chuck construction is achieved.

Preferably the wafer holder of the wafer handling system forms part of a quartz boat for a high temperature furnace. Current quartz boats are providing triples of quartz fingers extending radially below each single wafer to be supported in the furnace. Three protruding finger-like tips of the quartz boat define wafer contacting portions when the wafer is resting on the triple of fingers. As the quartz fingers of each triple are allocated in a fixed position to each other, wafer contacting portions are allocated in fixed distances from each other for all wafers in a quartz boat. As a consequence, each wafer may be supported by the same wafer chuck with one single set of recesses allocated in the wafer support region of the wafer chuck.

Preferrably the wafer handling system further comprises wafer transport means tansporting a wafer from the set of support members to the wafer chuck, the transport means locating the wafer on the wafer chuck in a position and/or in an orientation such that the support member contacting portions of the wafer predefined by the support members are located on the recesses of the wafer chuck. The wafer transport means transferring the wafer from the support members to the chuck thereby provide for proper position of the wafer on the chuck, the support member contacting portions of the wafer being allocated within the recesses of the wafer chuck.

According to a preferred embodiment the wafer transport means comprise rotational position adjusting means adjusting the rotational position of a wafer before it is located on the wafer chuck. As in most cases the rotational position of the wafer is changing when the wafer is transferred from the quartz boat to the wafer chuck, the wafer is rotated correspondingly for fitting the position of wafer contacting portions to the the position recesses. Hence wafer rotating means are provided rotating the wafer such that the positions of its support member contacting portions are corresponding to the positions of the recesses of the wafer chuck.

Hereinbelow the invention is described with respect to the accompanying figures. The figures show:
- Figure 1: a wafer chuck according to the present invention and a wafer disposed in a lithography device,
- Figure 2: a combined schematic view of the positions of support members, of support member contacting portions of a wafer surface and of recesses of a wafer chuck according to the invention,
- Figure 3: a schematic view of an embodiment of a wafer chuck according to the present invention and
- Figure 4: a wafer on a set of wafer support members of a quartz boat, the quartz boat being in a high temperature furnace.
- Figure 5: a wafer handling system according to the present ivention.

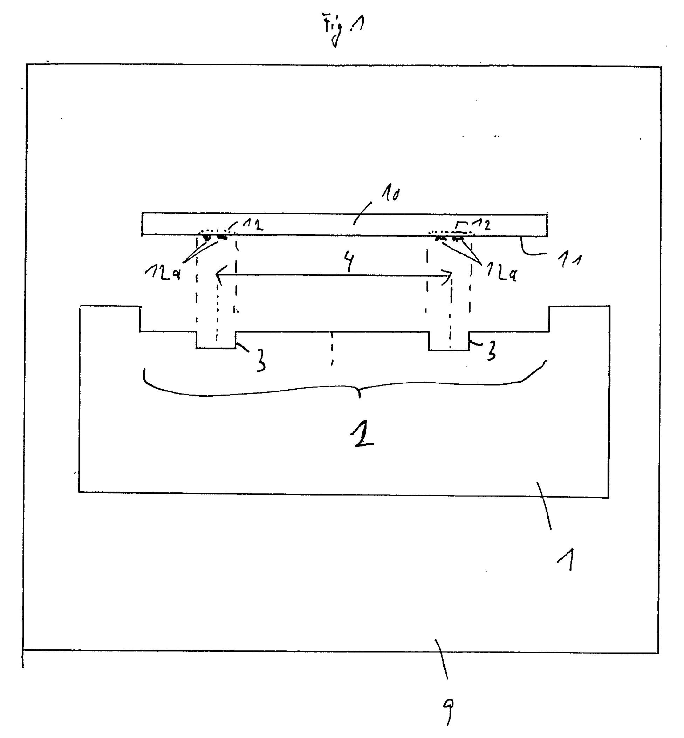

Figure 1 shows a wafer chuck 1 and a wafer 10 to be supported by the wafer chuck 1 provided in a lithography device 9. The wafer chuck 1 provides a wafer support region 2, the cross-section of the wafer support region 2 corresponding to the circumference of the planar surface 11 of the wafer 10. In figure 1 the wafer chuck 1 and the wafer 10 are represented in cross-sectional view through the symmetry axis of the wafer extending perpendicular to the wafer plane in the center of the circular semiconductor wafer 10. In the wafer support region 2 of the wafer chuck 1 two recesses 3 are illustrated. To support a semiconductor wafer, at least three recesses 3 are required (the number of three recesses being the optimum number of contact points). As the cross-sectional view in figure 1 is intersecting the wafer chuck 1 and the wafer 10 symmetrically, only a single recess 3 is allocated in the drawing plane. However, the illustration of two recesses 3 has been preferred for better representation of the invention in two dimensions.

The recesses 3 are allocated at predefined positions 4 in the wafer support region 2, the predefined positions 4 corresponding to support member contacting portions 12 of the wafer surface 11. In case of proper rotational position of the wafer 10 on the wafer chuck 1, the support member contacting portions 12 of the wafer back surface 11 probably covered with elevations 12a and the recesses 3 of the wafer chuck 1 are allocated at the same lateral positions 4 if seen from above onto the wafer and wafer chuck surfaces.

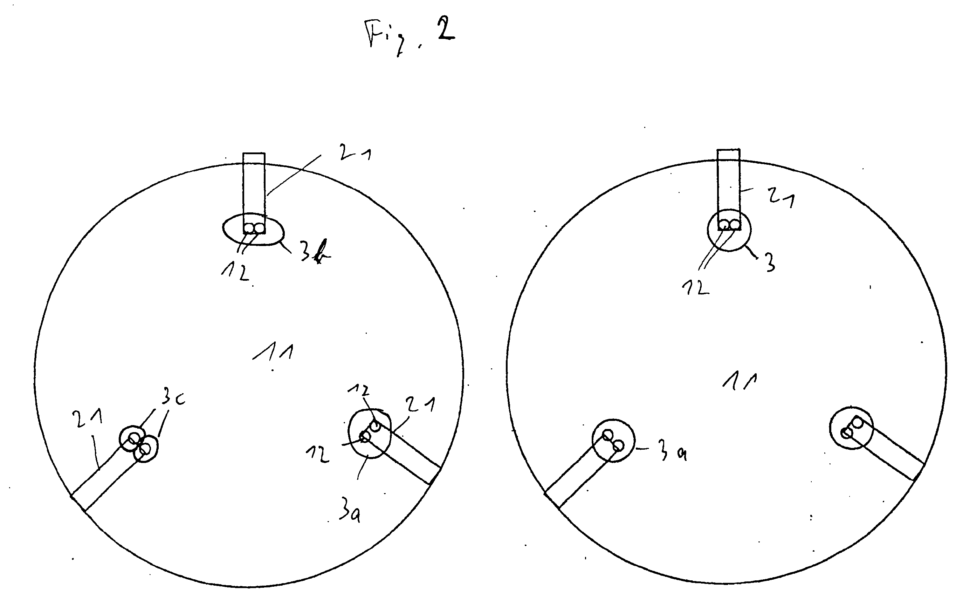

Figure 2 shows a combined schematic view of the positions of support members 21, of support member contacting portions 12 of a wafer surface 11 and of recesses 3 of a wafer chuck 1 according to the invention.

In the right part of figure 2 a circular planar wafer plane 11 is illustrated, three portions 12 of the wafer plane 11 eventually covered with elevations (like scratches or deposited material) which lift a wafer from a wafer chuck. These elevations 12 are caused by support members like quartz fingers 21 of a quartz boat 20 contacting the lower side of the wafers at predetermined positions 12. As the elevated portions 12 are rather small in lateral dimension, the chuck is adapted to encapsulate these elevations. Therefore three circular recesses 3 are provided surrounding the elevations. Thereby wafer lifting is prevented, the wafer now completely being contacted by the wafer contacting region 2 of the wafer chuck 1.

Whereas in the right part of figure 2 an embodiment with three circular recesses 3a is illustrated, further embodiments are presented in the left part of figure 2. Often the wafer surface is bent in a high temperature furnace due to a different amount of thermal expansion in different regions of the wafer plane. As a consequence, often each quartz finger produces pairs of elevations 12. According to a first embodiment the wafer chuck provides three pairs of elliptical recesses 3b, each recess surrounding one pair of elevations 12. Alternatively, three pairs of recesses 3c are provided in the chuck, each recess surrounding on respective elevation 12.

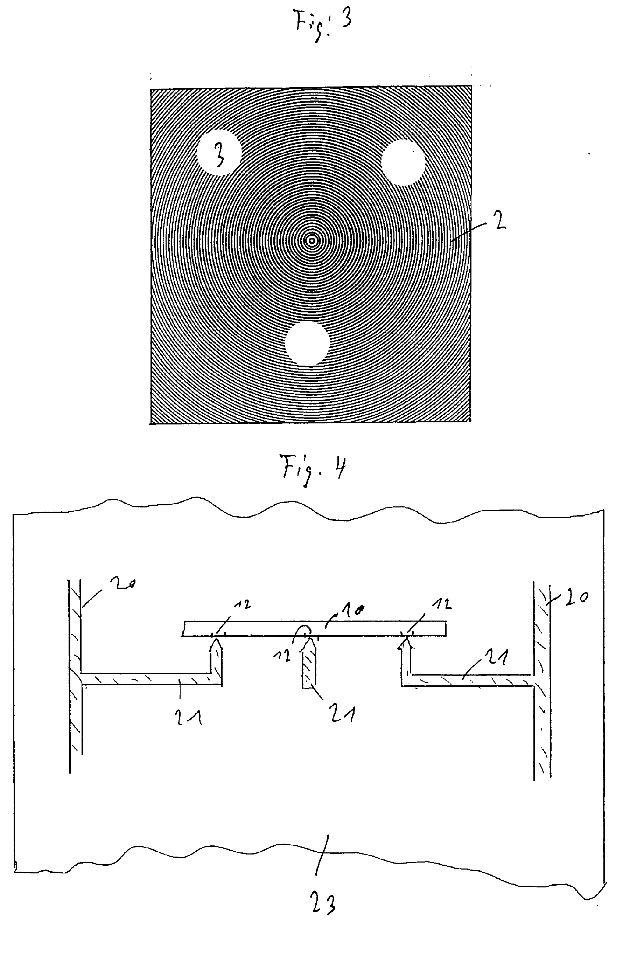

In case of a vacuum chuck, the chuck may be designed as a pin chuck or as a ring chuck. In these cases the wafer contacting region 2 is designed as a pattern of pins of concentric ring. According to the present invention, three recesses are superimposed on the resprective pattern of the wafer contacting region 2. Figure 3 illustrates a part of the wafer contacting region 2 of a ring chuck, the multitude of rings of the pattern forming the contact area for contacting the backside of a wafer by the wafer contacting region 2. The pattern of concentric rings around the center of the wafer contacting region 2 is recessed by three recesses 3 of a diameter larger than the ring-to-ring distance.

When a wafer is resting on such a ring chuck 3, sometimes the focus spot caused by elevations vanishes after a rotation of the wafer on the wafer chuck. This depends on whether an elevation is resting on a ring of the ring pattern or in the space between two adjacent rings. If an elevation of the wafer backside is located at one of the rings, the focus spot appears. In case that the elevation is located just between adjacent rings, the focus spot vanishes. Without any recesses 3 according to the invention, there is only an accidental chance of overcoming the problem of local wafer lifting caused by wafer backside elevations, whereas according to the invention the recesses safely surround and encapsulate such elevations.

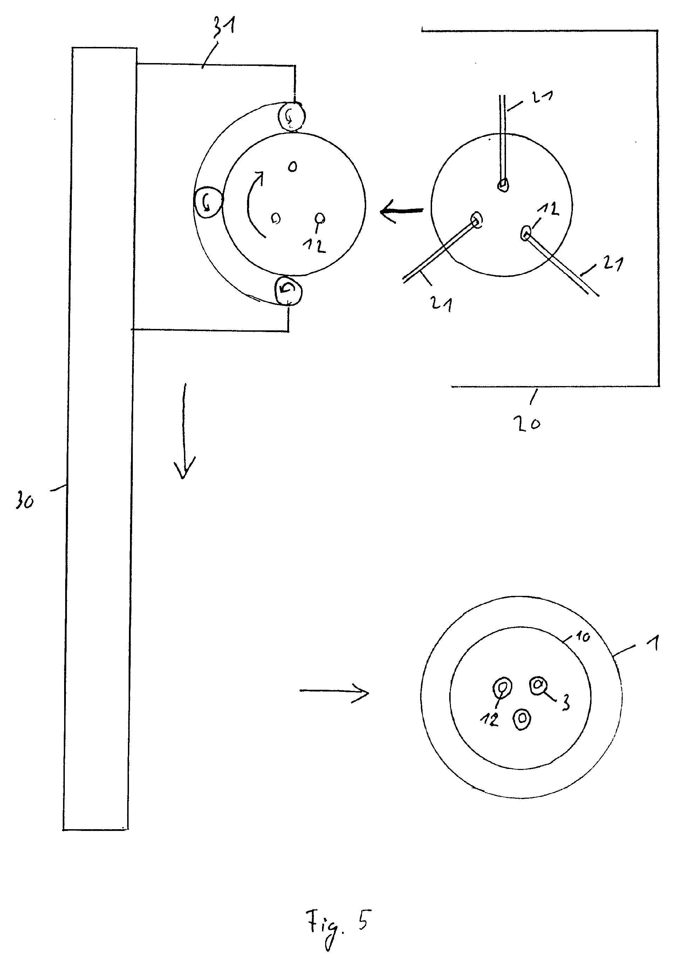

Figure 4 illustrates a quartz boat 20 supporting a wafer 10 in a high temperature furnace 23. The quartz boat supports several dozens of wafers, each wafer 10 being supported by a triple of support members which may be finger-like quartz fingers 21. As the tips of the quartz fingers 21 are in fixed positions relative to each other, they predefine contact areas 12 of the wafer 10 contacted. As all wafer positioned in a quartz boat are contacted by a respective set of support members or fingers, the three quartz fingers of each set being allocated in the same distance from each other and in the same rotational position relative to the location and to the orientation of the wafer, the support members predefine support member contacting portions 12 on the backside of the wafers, the position of the support member contacting portions 12 on the wafer back surface being identical for all wafers.

For this reason it is possible to encapsulate the scratches and other elevations on the back surface of the wafers by recesses 3 of a chuck 1 according to the present invention, the receses 3 being at the same positions of the wafer surface plane as the elevations. Therefore elevations need no longer be removed from the backside of the wafer for proper positioning of the wafer on the wafer chuck.

Figure 5 shows a wafer handling system comprising a wafer chuck 1, a wafer holder 20 having a set three of minimum contact wafer support members 21, the wafer support members predefining support member contacting portions 12 on the planar wafer surface. There are provided wafer transport means 30 for transporting the wafer from the wafer holder 20 (which may be a quartz boat in a high, for instance) to the wafer chuck 1. The transport means locate the wafer on the wafer chuck in a position and/or in an orientation such that the support member contacting portions 12 of the wafer 10 predefined by the support members 21 are located on the recesses 3 of the wafer chuck 1. The the wafer transport means 30 comprise rotational position adjusting means 31 adjusting the rotational position of a wafer 10 transported before the wafer is located on the wafer chuck 1.

### Reference list:

- 1: wafer chuck
- 2: support region
- 3: recess
- 4: predefined position corresponding to 12
- 9: lithography device
- 10: semiconductor wafer
- 11: planar wafer surface
- 12: support member contacting portion
- 20: wafer holder
- 21: support member
- 23: high temperature furnace
- 30: wafer transport means
- 31: rotational position adjusting means

## Claims

1. Wafer chuck (1) for supporting a semiconductor wafer (10) in semiconductor product manufacturing,
- the wafer chuck (1) having a wafer support region (2) for supporting the wafer (10) and
- the wafer support region (2) being constructed for contacting a planar wafer surface (11),
**characterized in that**
the wafer support region (2) of the wafer chuck (1) comprises recesses (3) allocated at predefined positions (4) corresponding to support member contacting portions (12) of the planar wafer surface (11).

2. Wafer chuck according to claim 1,
**characterized in that**
the recesses (3) are allocated symmetrically around the center of the wafer support region (2).

3. Wafer chuck according to claim 1 or 2,
**characterized in that**
the recesses (3a) have a circular cross-section in the wafer support region (2).

4. Wafer chuck according to one of claims 1 to 3,
**characterized in that**
the cross-section of the recesses (3) is 5 to 15 mm in diameter.

5. Wafer chuck according to claim 1 or 2,
**characterized in that**
the recesses (3b) have an elliptical cross-section in the wafer support region (2).

6. Wafer chuck according to claim 1 or 3,
**characterized in that**
the wafer chuck (1) comprises three pairs of recesses (3c), both recesses (3c) of each respective pair being allocated adjacent to each other and the three pairs of recesses (3c) being allocated symmetrically around the center of the wafer support region (2).

7. Wafer chuck according to one of claims 1 to 6,
**characterized in that**
the depth of the recesses (3) is between 10 and 100 µm from the wafer support region (2).

8. Wafer chuck according to one of claims 1 to 7,
**characterized in that**
the wafer chuck (1) is a vacuum chuck.

9. Wafer chuck according to claim 8,
**characterized in that**
the vacuum chuck (1) is a pin chuck.

10. Wafer chuck according to claim 8,
**characterized in that**
the vacuum chuck (1) is a ring chuck.

11. Lithography device (9) comprising a wafer chuck (1) according to one of claims 1 to 10.

12. Wafer handling system comprising a wafer chuck (1) according to one of claims 1 to 10, the wafer handling system further comprising a wafer holder (20) having a set of minimum contact wafer support members (21), the wafer support members (21) predefining support member contacting portions (12) on the planar wafer surface (11).

13. Wafer handling system according to claim 13,
**characterized in that**
the wafer holder (21) forms part of a quartz boat (12) for a high temperature furnace (23).

14. Wafer handling system according to claim 12 or 13,
**characterized in that**
the wafer handling system further comprises wafer transport means (30) tansporting a wafer (10) from the set of support members (21) to the wafer chuck (1), the transport means (30) locating the wafer on the wafer chuck (1) in a position and/or in an orientation such that the support member contacting portions (12) of the wafer (10) predefined by the support members (21) are located on the recesses (3) of the wafer chuck (1).

15. Wafer handling system according to one of claims 12 to 14,
**characterized in that**
the wafer transport means (30) comprise rotational position adjusting means (31) adjusting the rotational position of a wafer (10) transported before the wafer is located on the wafer chuck (1).
